# EUROPEAN PATENT APPLICATION

(11) **EP 4 571 747 A1**
(43) Date of publication of application: **18.06.2025**
(21) Application number: 24191482.9
(22) Date of filing: 29.07.2024
(51) Int. Cl.: G11C 5/02

(54) **COMPUTING-IN-MEMORY CHIP ARCHITECTURE, PACKAGING METHOD, AND APPARATUS**

(30) Priority: 13.12.2023 CN 202311715747
(71) Applicant: Hangzhou Zhicun (Witmem) Technology Co., Ltd., Hangzhou, Zhejiang 311100 (CN)
(72) Inventor: TIAN, Yu, HANGZHOU, ZHEJIANG, 311100 (CN); GUO, Xinjie, HANGZHOU, ZHEJIANG, 311100 (CN); SUN, Xuguang, HANGZHOU, ZHEJIANG, 311100 (CN)
(74) Representative: Lucke, Andreas

(57) **Abstract**

The present disclosure relates to a computing-in-memory chip architecture, a packaging method for a computing-in-memory chip, and an apparatus. The computing-in-memory chip architecture includes: one or more first sub-chips integrated on a first side of a computing-in-memory chip and integrated with one or more arrays of computing-in-memory cells of the computing-in-memory chip, where the one or more arrays of computing-in-memory cells are used to compute the received data; a second sub-chip integrated on a second side, opposite to the first side, of the computing-in-memory chip and integrated with a peripheral analog circuit IP core and a digital circuit IP core of the computing-in-memory chip; and an interface module configured to communicatively couple the second sub-chip to each of the one or more first sub-chips.

## Description

### TECHNICAL FIELD

The present disclosure relates to the technical field of computing-in-memory chips, and in particular, to a computing-in-memory chip architecture, a packaging method for a computing-in-memory chip, and an apparatus.

### BACKGROUND

The von Neumann architecture on which computers typically operate includes two separate parts, namely, a memory and a processor. When instructions are executed, data needs to be written to the memory, instructions and data are read from the memory in sequence via the processor, and finally execution results are written back to the memory. Accordingly, data is frequently transferred between the processor and the memory. If a transfer speed of the memory cannot match an operating speed of the processor, the computing power of the processor may be limited. For example, it takes 1 ns for the processor to execute an instruction, while it takes 10 ns for the instruction to be read and transferred from the memory. This significantly reduces the operating speed of the processor, and thus reduces the performance of the entire computing system.

Methods described in this section are not necessarily methods that have been previously conceived or employed. It should not be assumed that any of the methods described in this section is considered to be the prior art because it is included in this section, unless otherwise indicated expressly. Similarly, the problem mentioned in this section should not be considered to be recognized in any prior art, unless otherwise indicated expressly.

### SUMMARY

According to a first aspect of the present disclosure, a computing-in-memory chip architecture is provided. The computing-in-memory chip architecture includes: one or more first sub-chips integrated on a first side of a computing-in-memory chip and integrated with one or more arrays of computing-in-memory cells of the computing-in-memory chip, where the one or more arrays of computing-in-memory cells are used to compute the received data; a second sub-chip integrated on a second side, opposite to the first side, of the computing-in-memory chip and integrated with a peripheral analog circuit IP core and a digital circuit IP core of the computing-in-memory chip; and an interface module configured to communicatively couple the second sub-chip to each of the one or more first sub-chips.

According to a second aspect of the present disclosure, a packaging method for a computing-in-memory chip is provided, where the computing-in-memory chip includes one or more first sub-chips integrated on a first side, and a second sub-chip integrated on a second side opposite to the first side. The packaging method includes: integrating one or more arrays of computing-in-memory cells on the one or more first sub-chips, where the one or more arrays of computing-in-memory cells are used to compute the received data; integrating a peripheral analog circuit IP core and a digital circuit IP core on the second sub-chip; and communicatively coupling, through an interface module, the second sub-chip to each of the one or more first sub-chips.

According to a third aspect of the present disclosure, an apparatus is provided which includes the computing-in-memory chip architecture described above.

According to one or more embodiments of the present disclosure, by integrating the array of computing-in-memory cells on one side of a chip, and integrating the peripheral analog circuit IP core and the digital circuit IP core on the other side of the chip, the chip may be fully utilized, allowing for a computing-in-memory chip architecture based on a single chip. In this way, the number of chips and the area required for the chips may be significantly reduced, thereby reducing production costs.

According to another one or more embodiments of the present disclosure, since the production processes and yields of different chips may be different, the method may also facilitate yield improvement and fault detection of computing-in-memory chip packages.

These and other aspects of the present disclosure will be apparent from the embodiments described below, and will be clarified with reference to the embodiments described below.

### BRIEF DESCRIPTION OF THE DRAWINGS

More details, features, and advantages of the present disclosure are disclosed in the following description of exemplary embodiments with reference to the accompanying drawings, in which:
FIG. 1 is a schematic diagram of a computing-in-memory chip architecture according to some embodiments of the present disclosure;
FIG. 2 is a schematic diagram of a second sub-chip in a computing-in-memory chip architecture according to some embodiments of the present disclosure;
FIG. 3 is a schematic diagram of a computing-in-memory chip architecture according to some other embodiments of the present disclosure;
FIG. 4 is a flow chart of a packaging method for a computing-in-memory chip according to some embodiments of the present disclosure;
FIG. 5 is a flow chart of a packaging method for a computing-in-memory chip according to some other embodiments of the present disclosure; and
FIG. 6 is a flow chart of a packaging method for a computing-in-memory chip according to yet other embodiments of the present disclosure.

### DETAILED DESCRIPTION OF EMBODIMENTS

It is noted that although terms such as first, second and third may be used herein to describe various elements, components, areas, layers and/or parts, these elements, components, areas, layers and/or parts should not be limited by these terms. These terms are merely used to distinguish one element, component, area, layer or part from another. Therefore, a first element, component, area, layer or part discussed below may be referred to as a second element, component, area, layer or part without departing from the teaching of the present disclosure.

Terms regarding spatial relativity such as "under", "below", "lower", "beneath", "above" and "upper" may be used herein to describe the relationship between one element or feature and another element(s) or feature(s) as illustrated in the figures. It is noted that these terms are intended to cover different orientations of a device in use or operation in addition to the orientations depicted in the figures. For example, if the device in the figures is turned over, an element described as being "below other elements or features" or "under other elements or features" or "beneath other elements or features" will be oriented to be "above other elements or features". Thus, the exemplary terms "below" and "beneath" may cover both orientations "above" and "below". Terms such as "before" or "ahead" and "after" or "then" may similarly be used, for example, to indicate the order in which light passes through elements. The device may be oriented in other ways (rotated by 90° or in other orientations), and the spatially relative descriptors used herein are interpreted correspondingly. In addition, it will also be understood that when a layer is referred to as being "between two layers", it may be the only layer between the two layers, or there may also be one or more intermediate layers.

The terms used herein are merely for the purpose of describing specific embodiments and are not intended to limit the present disclosure. As used herein, the singular forms "a", "an", and "the" are intended to include plural forms as well, unless otherwise explicitly indicated in the context. Further, it is noted that the terms "comprise" and/or "include", when used in the description, specify the presence of described features, entireties, steps, operations, elements and/or components, but do not exclude the presence or addition of one or more other features, entireties, steps, operations, elements, components and/or groups thereof. As used herein, the term "and/or" includes any and all combinations of one or more of the associated listed items, and the phrase "at least one of A and B" refers to only A, only B, or both A and B.

It is noted that when an element or a layer is referred to as being "on another element or layer", "connected to another element or layer", "coupled to another element or layer", or "adjacent to another element or layer", the element or layer may be directly on another element or layer, directly connected to another element or layer, directly coupled to another element or layer, or directly adjacent to another element or layer, or there may be an intermediate element or layer. On the contrary, when an element is referred to as being "directly on another element or layer", "directly connected to another element or layer", "directly coupled to another element or layer", or "directly adjacent to another element or layer", there is no intermediate element or layer. However, under no circumstances should "on" or "directly on" be interpreted as requiring one layer to completely cover the underlying layer.

Embodiments of the present disclosure are described herein with reference to schematic illustrations (and intermediate structures) of idealized embodiments of the present disclosure. On this basis, variations in an illustrated shape, for example as a result of manufacturing techniques and/or tolerances, should be expected. Therefore, the embodiments of the present disclosure should not be interpreted as being limited to a specific shape of an area illustrated herein, but should comprise shape deviations caused due to manufacturing, for example. Therefore, the area illustrated in a figure is schematic, and the shape thereof is neither intended to illustrate the actual shape of the area of a device, nor to limit the scope of the present disclosure.

Unless otherwise defined, all terms (including technical and scientific terms) used herein have the same meanings as commonly understood by those of ordinary skill in the art to which the present disclosure belongs. It is further noted that the terms such as those defined in dictionaries should be interpreted as having meanings consistent with the meanings thereof in relevant fields and/or in the context of the description, and will not be interpreted in an ideal or too formal sense, unless defined explicitly herein.

The von Neumann architecture on which computers typically operate includes two separate parts, namely, a memory and a processor. When instructions are executed, data needs to be written to the memory, instructions and data are read from the memory in sequence via the processor, and finally execution results are written back to the memory. Accordingly, data is frequently transferred between the processor and the memory. If a transfer speed of the memory cannot match an operating speed of the processor, the computing power of the processor may be limited, and thus the performance of the entire computing system is reduced.

To improve the computing power of the processor and alleviate the above problem, computing-in-memory chips have been rapidly developed. Such chips have a computing unit with computing power embedded into a memory. Control of an operating mode of the computing-in-memory chip may allow both data computation and data storage in the chip. Since there is no need to frequently transfer data between the processor and the memory, data transfer latency and power consumption can be reduced, and the performance of the entire computing system can be improved.

The inventors notice that such computing-in-memory chips usually include a computing unit with a computing function, a unit for processing and storing computed data, etc. The computing unit is usually implemented based on an analog circuit and has low requirements for a process node, while other units are mainly implemented based on a digital circuit and have high requirements for a process node. Currently, such computing-in-memory chips can be integrated by integrating the computing unit and the other units on different chips. However, when there is a large amount of data computations, in order to increase the processing speed of chips, a plurality of chips including the computing units need to be provided in the computing-in-memory chip architecture, which increases the number of chips, and in turn production costs.

In view of the above technical problems, one or more embodiments of the present disclosure provide a computing-in-memory chip architecture, a packaging method for a computing-in-memory chip, and an apparatus. Various embodiments of the present disclosure are described in detail below in conjunction with the drawings.

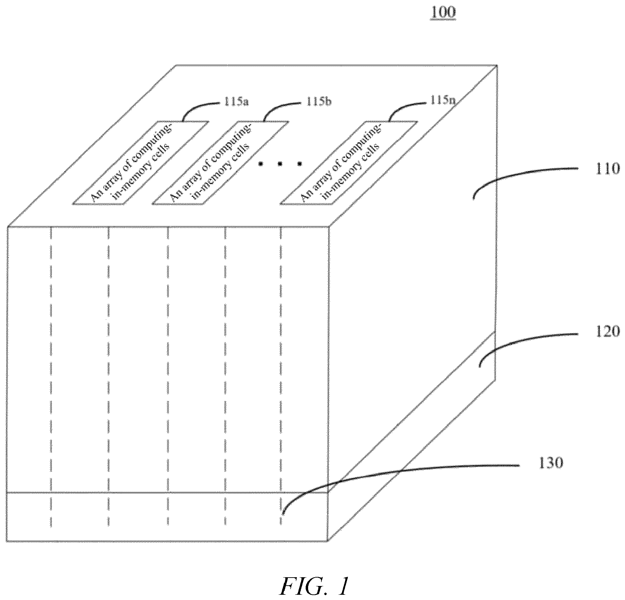

FIG. 1 illustrates a schematic diagram of a computing-in-memory chip architecture 100 according to some embodiments of the present disclosure. As shown in FIG. 1, the computing-in-memory chip architecture 100 may include: one or more first sub-chips 110 integrated on a first side of a computing-in-memory chip and integrated with one or more arrays of computing-in-memory cells 115a to 115n of the computing-in-memory chip, where the one or more arrays of computing-in-memory cells are used to compute the received data; a second sub-chip 120 integrated on a second side, opposite to the first side, of the computing-in-memory chip and integrated with a peripheral analog circuit IP core and a digital circuit IP core of the computing-in-memory chip; and an interface module 130 configured to communicatively couple the second sub-chip 120 to each of the one or more first sub-chips 110.

It is noted that the computing-in-memory chip architecture may refer to a computing-in-memory chip interconnection integrated structure, a computing-in-memory chip product, etc.

By integrating the array of computing-in-memory cells on one side of a chip and integrating the peripheral analog circuit IP core and the digital circuit IP core on the other side of the chip, the chip may be fully utilized, allowing for a computing-in-memory chip architecture based on a single chip. In this way, the number of chips and the area required for the chips may be significantly reduced, thereby reducing production costs. In addition, since the production processes and yields of different chips may be different, the method may also facilitate yield improvement and fault detection of computing-in-memory chip packages.

According to some embodiments of the present disclosure, the arrays of computing-in-memory cells on the first sub-chip may be implemented based on an analog circuit, that is, used for computing the received analog data, e.g., for computing a voltage and a current according to Kirchhoff's law or Ohm's law, various addition operations, multiplication operations, matrix multiplication operations, etc. It is noted that the arrays of computing-in-memory cells on the first sub-chip 110 may also be implemented based on a digital circuit. It is also noted that, although n arrays of computing-in-memory cells are shown in FIG. 1, the computing-in-memory chip may include only one array of computing-in-memory cells.

According to some embodiments of the present disclosure, the peripheral analog circuit IP core integrated on the second sub-chip is a functional module based on an analog signal. In some examples, the peripheral analog circuit IP core may include one or more of: a programming circuit module coupled to the one or more arrays of computing-in-memory cells and configured to perform data programming on the one or more arrays of computing-in-memory cells; a digital-to-analog conversion module coupled to the one or more arrays of computing-in-memory cells and configured to convert digital data to be input to the one or more arrays of computing-in-memory cells into analog data; an analog-to-digital conversion module coupled to the one or more arrays of computing-in-memory cells and configured to convert analog data computed by the one or more arrays of computing-in-memory cells into digital data; a phase-locked loop; and an oscillator.

In some other examples, the peripheral analog circuit IP core may further include, for example, an input interface module, an input register file, an output register file, and an output interface module.

In still other examples, the peripheral analog circuit IP core may further include a calibration module for calibrating data obtained by the one or more arrays of computing-in-memory cells; and a compensation module for performing signal compensation on the data obtained by the one or more arrays of computing-in-memory cells. The use of the calibration module and the compensation module may further increase the accuracy of the chips, thereby effectively mitigating the interference of data transfer between different chips through an analog signal.

According to some embodiments of the present disclosure, the digital circuit IP core integrated on the second sub-chip is a functional module based on a digital signal. In some examples, the digital circuit IP core may include one or more of: a post-processing operation circuit configured to perform a post-processing operation on the digital data converted by the analog-to-digital conversion module; a random-access memory (RAM); a central processing unit (CPU); a graphics processing unit (GPU); and a peripheral interface module.

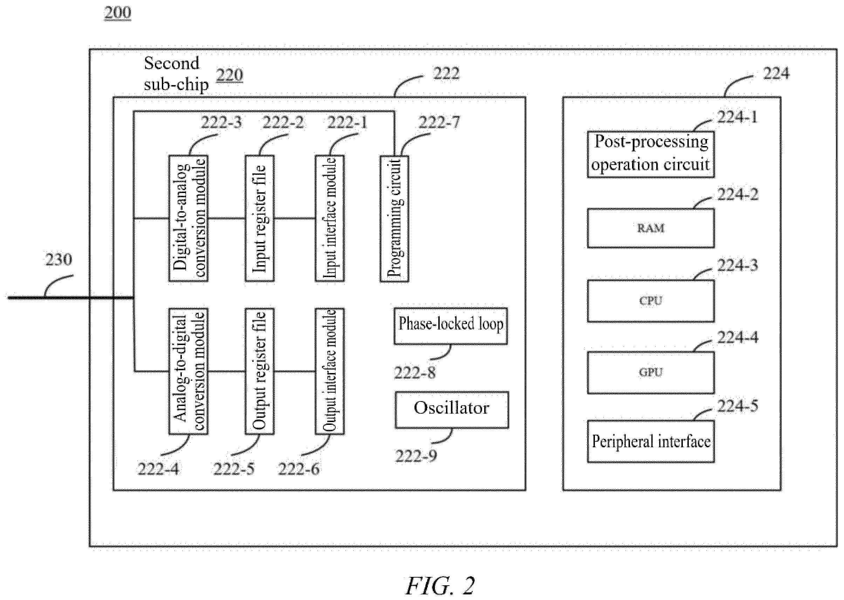

The modules of the peripheral analog circuit IP core and the digital circuit IP core will be described in detail below with reference to FIG. 2.

According to some embodiments of the present disclosure, the interface module 130 may be configured to transfer data between each first sub-chips 110 and the second sub-chip 120 through an analog signal.

When the computing unit and the other units are integrated on different chips, information is usually transferred between the chips through a digital signal, resulting in a high transfer power consumption. For example, transfer of data that is 8-bit wide requires eight digital signals, but only one analog signal. Therefore, the use of the analog signal to transfer data between each first sub-chip and the second sub-chip may significantly reduce the number of signals required for data transfer, thereby effectively reducing the power consumption.

According to some embodiments of the present disclosure, the interface module 130 may be an electrical interconnect between the first sub-chip and the second sub-chip. For example, the electrical interconnect may be a metal pin on the first sub-chip and the second sub-chip. According to some other embodiments of the present disclosure, the interface module 130 may also be a bus through which signals are transferred between the first sub-chip and the second sub-chip. According to still other embodiments of the present disclosure, the interface module 130 may include a through-silicon via (TSV) structure.

FIG. 2 illustrates a schematic diagram of a second sub-chip 220 of a computing-in-memory chip architecture 200 according to some embodiments of the present disclosure. For the purpose of simplicity, FIG. 2 illustrates only the second sub-chip 220 and an interface module 230. It is noted that the computing-in-memory chip architecture 200 may further include one or more first sub-chips (including arrays of computing-in-memory cells) similar to those in the computing-in-memory chip architecture 100 described with reference to FIG. 1. For the purpose of simplicity, features, operations, and functions of the similar components are omitted.

As shown in FIG. 2, a peripheral analog circuit IP core 222 in the computing-in-memory chip architecture 200 may include: an input interface module 222-1 for receiving data to be processed; an input register file 222-2 coupled to the input interface module 222-1 and configured to register the data to be processed from the input interface module; a digital-to-analog conversion module 222-3 coupled to one or more arrays of computing-in-memory cells 215a to 215n of the first sub-chip and the input register file 222-2, and configured to convert digital data to be processed from the input interface module 222-1 into analog data; an analog-to-digital conversion module 222-4 also coupled to the one or more arrays of computing-in-memory cells 215a to 215n of the first sub-chip, and configured to convert analog data obtained by processing via the arrays of computing-in-memory cells into digital data; an output register file 222-5 coupled to the analog-to-digital conversion module 222-4 and configured to register digital data converted from the analog data obtained by processing via the one or more arrays of computing-in-memory cells 215a to 215n; an output interface module 222-6 coupled to the output register file 222-5 and configured to output the registered digital data; a programming circuit 222-7 coupled to the one or more arrays of computing-in-memory cells 215a to 215n of the first sub-chip, which, in some examples, may include a voltage generation circuit and a voltage control circuit, so as to perform data programming on the one or more arrays of computing-in-memory cells of the first sub-chip by controlling a voltage; a phase-locked loop 222-8 for providing a synchronized clock signal; and an oscillator 222-9 for generating a stable signal with a specific frequency.

Still referring to FIG. 2, a digital circuit IP core 224 in the computing-in-memory chip architecture 200 may include: a post-processing operation circuit 224-1 configured to, for example, perform post-processing operations such as shifting or activation on the digital data obtained by the analog-to-digital conversion module 222-4; a random-access memory (RAM) 224-2; a central processing unit (CPU) 224-3; a graphics processing unit (GPU) 224-4; and a peripheral interface 224-5.

It is noted that FIG. 2 illustrates one implementation of the peripheral analog circuit IP core and the digital circuit IP core in the computing-in-memory chip architecture for illustrative purposes only. The peripheral analog circuit IP core may further include one or more other modules, such as an analog data preprocessing module, and the digital circuit IP core may also include one or more other modules, such as a codec module. In addition, although FIG. 2 illustrates coupling manners between the modules included in the peripheral analog circuit IP core and the digital circuit IP core, it is understood that these modules may also be coupled in any other manner. The scope of protection of the present disclosure is not limited in this respect.

According to some embodiments of the present disclosure, the peripheral analog circuit IP core may include one or more modules, and the second sub-chip may further be divided into one or more sub-chips each integrated with any of the one or more modules or a combination thereof.

According to some other embodiments of the present disclosure, the digital circuit IP core may also include one or more modules, and the second sub-chip may further be divided into one or more sub-chips each integrated with any of the one or more modules or a combination thereof.

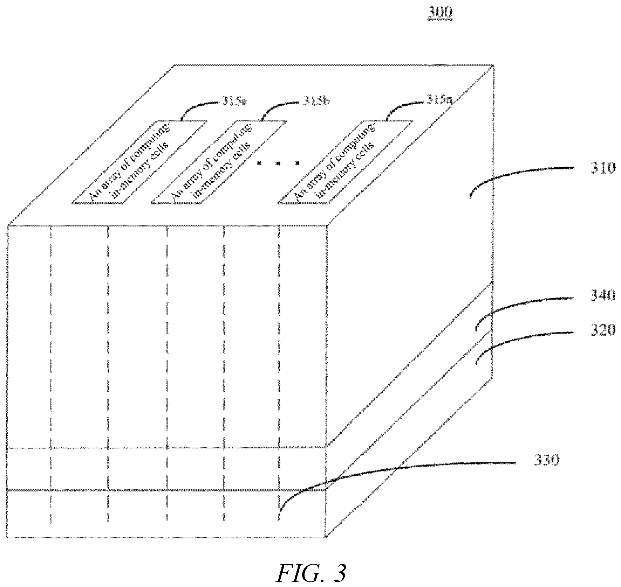

FIG. 3 illustrates a schematic diagram of a computing-in-memory chip architecture 300 according to some other embodiments of the present disclosure. As shown in FIG. 3, the computing-in-memory chip architecture 300 may include: one or more first sub-chips 310 integrated on a first side of a computing-in-memory chip and integrated with one or more arrays of computing-in-memory cells 315a to 315n of the computing-in-memory chip, where the one or more arrays of computing-in-memory cells are used to compute the received data; a second sub-chip 320 integrated on a second side, opposite to the first side, of the computing-in-memory chip and integrated with a peripheral analog circuit IP core and a digital circuit IP core of the computing-in-memory chip; an interface module 330 configured to communicatively couple the second sub-chip 320 to each of the one or more first sub-chips 310; and an interposer 340 between the one or more first sub-chips 310 and the second sub-chip 320 and integrated on the second side of the computing-in-memory chip.

It is noted that features, operations and functions of the first sub-chips 310 (including the arrays of computing-in-memory cells 315a to 315n), the second sub-chip 320 (including the peripheral analog circuit IP core and the digital circuit IP core), and the interface module 330 may be the same as or similar to those of similar components in the computing-in-memory chip architectures 100 and 200 described in FIGS. 1 and 2.Thus, details are omitted.

Arrangement of an interposer between the array of computing-in-memory cells and the peripheral analog circuit IP core and digital circuit IP core may effectively mitigate low-rate communication with a logic chip (i.e., the second sub-chip) in a case of excessive data computations of the array of computing-in-memory cells (for example, especially in a case that there are a large number of first sub-chips), thereby facilitating high-speed data transfer.

According to some embodiments of the present disclosure, the interface module 330 may include one or more sub-interface modules on each first sub-chip 310 and aligned with each other. And the interposer 340 may include a first portion aligned with the one or more sub-interface modules on each first sub-chip 310, and a second portion configured to arrange a communication path between the second sub-chip 320 and each first sub-chip 310.

By arranging an interposer between the first sub-chip and the second sub-chip and aligned interface channels for each first sub-chip, as well as relatively complex communication paths in the interposed, a larger number of first sub-chips can be packaged and a disorderly arrangement of the interface channels may be avoided, since according to the computing-in-memory chip architecture of the present application, the interface channels of the first sub-chip are uniformly arranged and aligned, and communication paths are arranged only in a lower area of the interposer. Therefore, an increase in the number of first sub-chips requires only an adjustment to the arrangement of communication paths in the interposer, without rearranging new interface channels, which significantly simplifies the process and improves the packaging and manufacturing efficiency of the computing-in-memory chip.

According to some embodiments of the present disclosure, the one or more arrays of computing-in-memory cells may be integrated on the first sub-chip through a first process node, and the peripheral analog circuit IP core and the digital circuit IP core may be integrated, through a second process node different from the first process node, on the second sub-chip.

In some examples, the arrays of computing-in-memory cells may be implemented based on an analog circuit. Since analog signals in analog circuits are susceptible to noise interference, integration of the arrays of computing-in-memory cells, and the peripheral analog circuit IP core and the digital circuit IP core on different chips through different process nodes may effectively mitigate the interference between these modules and ensure the accuracy and credibility of data. In addition, based on different implementations of the two types of circuits, more appropriate process nodes may be selected, thereby reducing process costs.

According to some embodiments of the present disclosure, the line width of the second process node for integrating the peripheral analog circuit IP core and the digital circuit IP core may be less than that of the first process node for integrating the arrays of one or more computing-in-memory cells.

In some examples, the peripheral analog circuit IP core and the digital circuit IP core may be integrated on the second sub-chip through a process node with a line width of 14 nanometers (nm) or 7 nm.

In other examples, the arrays of one or more computing-in-memory cells may be integrated on the first sub-chip through a process node with a line width of 55 nm, 40 nm, or 28 nm.

In general, an implementation of chip based on an analog circuit has low requirements for a process node, because the use of an advanced process node with a smaller line width may cause distortion of the analog signal due to noise and reduce the accuracy. By contrast, an implementation of chip based on a digital circuit usually has high requirements for a process node, so as to improve the operating performance and accuracy of a chip. Therefore, the use of the process node with a smaller line width to integrate the peripheral analog circuit IP core and the digital circuit IP core, and the use of the process node with a larger line width to integrate the arrays of one or more computing-in-memory cells based on an analog circuit makes it possible to avoid high cost, excessive power consumption, and possible data distortion resulting from all using the advanced process nodes with a smaller line width to integrate different chips, and to avoid low operating performance of chips resulting from all using the process nodes with a larger line width to integrate different chips. This allows for a trade-off between performance, power consumption, and cost.

It is noted that the line widths of the first process node and the second process node can be selected based on actual scenarios. For example, the line width of the second process node may also be greater than or equal to that of the first process node.

According to some embodiments of the present disclosure, the one or more arrays of computing-in-memory cells, and the peripheral analog circuit IP core and the digital circuit IP core may also be integrated, through a same process node, on the one or more first sub-chips and the second sub-chip, respectively.

In this case, a more appropriate process node can be selected as needed. For example, when requirements for chip performance are not high and reduction of the power consumption and cost is desired, a process node with a line width of 28 nm can be selected to integrate the one or more arrays of computing-in-memory cells, and the peripheral analog circuit IP core and the digital circuit IP core on the first sub-chip and the second sub-chip, respectively. For another example, if high chip performance is desired, a process node with a line width lower than 28 nm can be selected to integrate the one or more arrays of computing-in-memory cells, and the peripheral analog circuit IP core and the digital circuit IP core on the first sub-chip and the second sub-chip, respectively.

The use of the same process node (that is, the same line width) to integrate different sub-chips may simplify operations required to integrate the chips and their complexity.

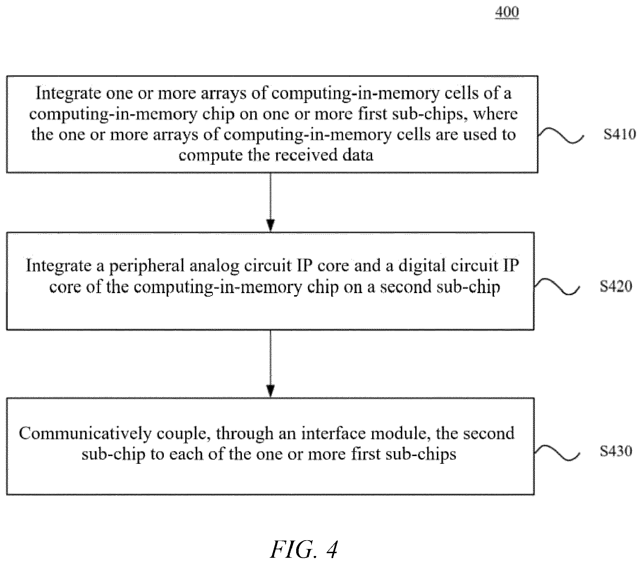

FIG. 4 illustrates a flow chart of a packaging method 400 for a computing-in-memory chip according to some embodiments of the present disclosure, where the computing-in-memory chip includes one or more first sub-chips integrated on a first side, and a second sub-chip integrated on a second side opposite to the first side. As shown in FIG. 4, the packaging method 400 may include: step S410: integrating one or more arrays of computing-in-memory cells on the one or more first sub-chips, where the one or more arrays of computing-in-memory cells are used to compute the received data; step S420: integrating a peripheral analog circuit IP core and a digital circuit IP core on the second sub-chip; and step S430: communicatively coupling, through an interface module, the second sub-chip to each of the one or more first sub-chips.

By integrating the array of computing-in-memory cells on one side of a chip and integrating the peripheral analog circuit IP core and the digital circuit IP core on the other side of the chip, the chip may be fully utilized, allowing for a computing-in-memory chip architecture based on a single chip. In this way, the number of chips and the area required for the chips may be significantly reduced, thereby reducing production costs. In addition, since the production processes and yields of different chips may be different, the method may also facilitate yield improvement and fault detection of computing-in-memory chip packages.

According to some embodiments of the present disclosure, step S410 of integrating the one or more arrays of computing-in-memory cells on the one or more first sub-chips may include: integrating, through a first process node, the one or more arrays of computing-in-memory cells on the one or more first sub-chips; and step S420 of integrating the peripheral analog circuit IP core and the digital circuit IP core on the second sub-chip may include: integrating, through a second process node different from the first process node, the peripheral analog circuit IP core and the digital circuit IP core on the second sub-chip.

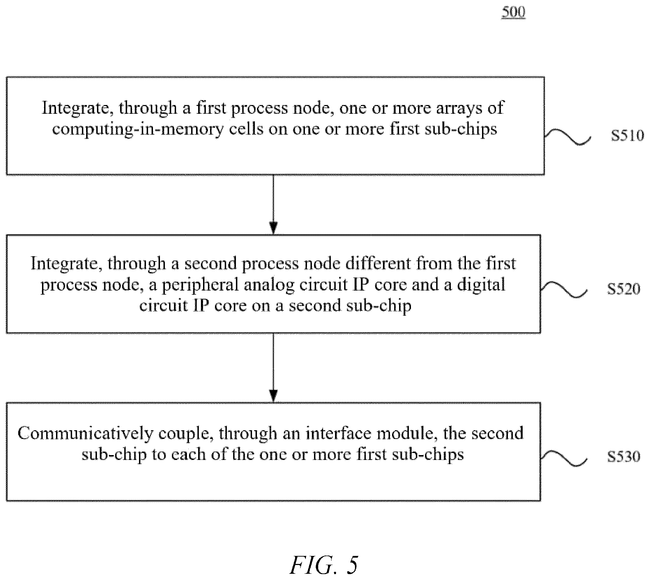

FIG. 5 illustrates a flow chart of a packaging method 500 for a computing-in-memory chip according to such embodiments of the present disclosure. As shown in FIG. 5, the packaging method 500 may include: step S510: integrating, through a first process node, one or more arrays of computing-in-memory cells on one or more first sub-chips; step S520: integrating, through a second process node different from the first process node, a peripheral analog circuit IP core and a digital circuit IP core on a second sub-chip; and step S530, which is similar to step S430 in FIG. 4: communicatively coupling, through an interface module, the second sub-chip to each of the one or more first sub-chips.

By integrating, through different process node, the arrays of computing-in-memory cells and the peripheral analog circuit IP core and the digital circuit IP core, interference between the arrays of computing-in-memory cells and the peripheral analog circuit IP core and the digital circuit IP core may be effectively mitigated, and the accuracy and credibility of data may be ensured. In addition, based on the different implementations of the two types of circuits, more appropriate process nodes may be selected, thereby reducing process costs.

According to some embodiments of the present disclosure, the line width of the second process node may be less than that of the first process node.

According to some embodiments of the present disclosure, the one or more arrays of computing-in-memory cells, and the peripheral analog circuit IP core and the digital circuit IP core may be integrated, through a same process node, on the one or more first sub-chips and the second sub-chip, respectively.

According to some embodiments of the present disclosure, the one or more arrays of computing-in-memory cells, and the peripheral analog circuit IP core and the digital circuit IP core are integrated, through a same process node, on the one or more first sub-chips and the second sub-chip, respectively.

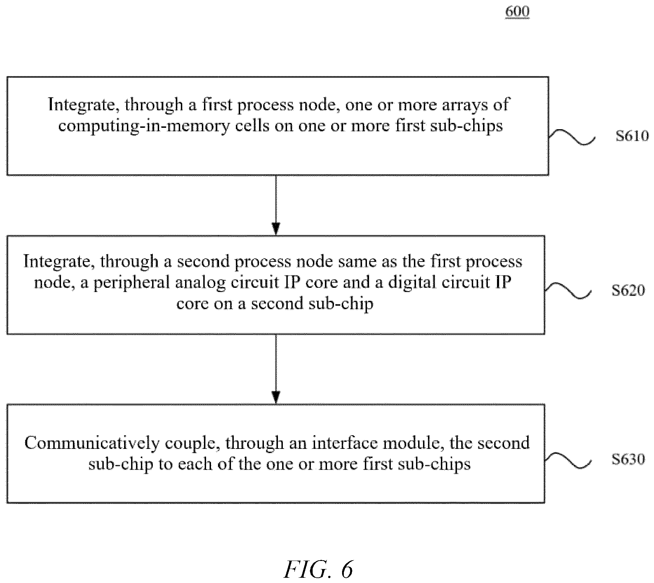

FIG. 6 illustrates a flow chart of a packaging method 600 for a computing-in-memory chip according to such embodiments of the present disclosure. As shown in FIG. 6, the packaging method 600 may include: step S610: integrating, through a first process node, one or more arrays of computing-in-memory cells on one or more first sub-chips; step S620: integrating, through a second process node same as the first process node, a peripheral analog circuit IP core and a digital circuit IP core on a second sub-chip; and step S630, which is similar to step S430 in FIG. 4 and step S530 in FIG. 5: communicatively coupling, through an interface module, the second sub-chip to each of the one or more first sub-chips.

As described above, in this case, a more appropriate process node can be selected as needed, and operations required to integrate the chips and their complexity can be simplified.

According to some embodiments of the present disclosure, the computing-in-memory chip may further include an interposer between the one or more first sub-chips and the second sub-chip and integrated on the second side of the computing-in-memory chip.

According to some embodiments of the present disclosure, the interface module may include one or more sub-interface modules on each first sub-chip and aligned with each other. And the interposer may include a first portion aligned with the one or more sub-interface modules on each first sub-chip, and a second portion configured to arrange a communication path between the second sub-chip and each first sub-chip.

According to some embodiments of the present disclosure, the interface module may be configured to transfer data between each first sub-chip and the second sub-chip through an analog signal.

According to some embodiments of the present disclosure, the interface module may include a through-silicon via (TSV) structure.

According to some embodiments of the present disclosure, the peripheral analog circuit IP core may include one or more of: a programming circuit module coupled to the one or more arrays of computing-in-memory cells and configured to perform data programming on the one or more arrays of computing-in-memory cells; a digital-to-analog conversion module coupled to the one or more arrays of computing-in-memory cells and configured to convert digital data to be input to the one or more arrays of computing-in-memory cells into analog data; an analog-to-digital conversion module coupled to the one or more arrays of computing-in-memory cells and configured to convert analog data computed by the one or more arrays of computing-in-memory cells into digital data; a phase-locked loop; and an oscillator.

According to some embodiments of the present disclosure, the digital circuit IP core may include one or more of: a post-processing operation circuit configured to perform a post-processing operation on the digital data converted by the analog-to-digital conversion module; a random-access memory (RAM); a central processing unit (CPU); a graphics processing unit (GPU); and a peripheral interface module.

It is noted that the steps of the packaging methods 400-600 shown in FIGS. 4-6 may correspond to the modules in the computing-in-memory chip architectures 100-300 described with reference to FIGS. 1-3. Therefore, the components, functions, features, and advantages described above for the computing-in-memory chip architectures 100-300 are applicable to the packaging methods 400-600 and the steps included therein. For the purpose of brevity, some operations, features, and advantages are not described herein.

Although the present disclosure has been illustrated and described in detail with reference to the accompanying drawings and the foregoing description, such illustration and description should be considered illustrative and schematic, rather than limiting; and the present disclosure is not limited to the disclosed embodiments. By studying the accompanying drawings, the disclosure, and the appended claims, those skilled in the art can understand and implement modifications to the disclosed embodiments when practicing the claimed subject matters. In the claims, the word "comprising" does not exclude other elements or steps not listed, the indefinite article "a" or "an" does not exclude plural, and the term "a plurality of" means two or more. The mere fact that certain measures are recited in different dependent claims does not indicate that a combination of these measures cannot be used to get benefit.

## Claims

1. A computing-in-memory chip architecture (100, 200, 300), comprising:
one or more first sub-chips (110, 310) integrated on a first side of a computing-in-memory chip and integrated with one or more arrays of computing-in-memory cells (115a, 115b, 115n, 315a, 315b, 315n) of the computing-in-memory chip, wherein the one or more arrays of computing-in-memory cells are used to compute the received data;
a second sub-chip (120, 220, 320) integrated on a second side, opposite to the first side, of the computing-in-memory chip and integrated with a peripheral analog circuit IP core (222) and a digital circuit IP core (224) of the computing-in-memory chip; and
an interface module (130, 230, 330) configured to communicatively couple the second sub-chip to each of the one or more first sub-chips.

2. The computing-in-memory chip architecture according to claim 1, further comprising: an interposer (340) between the one or more first sub-chips and the second sub-chip and integrated on the second side of the computing-in-memory chip.

3. The computing-in-memory chip architecture according to claim 2, wherein the interface module comprises one or more sub-interface modules on each first sub-chip and aligned with each other, and
wherein the interposer comprises a first portion aligned with the one or more sub-interface modules on each first sub-chip, and a second portion configured to arrange a communication path between the second sub-chip and each first sub-chip.

4. The computing-in-memory chip architecture according to any of the claims 1 to 3, wherein the interface module comprises a through-silicon via (TSV) structure.

5. The computing-in-memory chip architecture according to any of claims 1 to 4, wherein the peripheral analog circuit IP core (222) comprises one or more of:
a programming circuit module (222-7) coupled to the one or more arrays of computing-in-memory cells and configured to perform data programming on the one or more arrays of computing-in-memory cells;
a digital-to-analog conversion module (222-3) coupled to the one or more arrays of computing-in-memory cells and configured to convert digital data to be input to the one or more arrays of computing-in-memory cells into analog data;
an analog-to-digital conversion module (222-4) coupled to the one or more arrays of computing-in-memory cells and configured to convert analog data computed by the one or more arrays of computing-in-memory cells into digital data;
a phase-locked loop (222-8); and
an oscillator (222-9).

6. The computing-in-memory chip architecture according to claim 5, wherein the digital circuit IP core (224) comprises one or more of:
a post-processing operation circuit (224-1) configured to perform a post-processing operation on the digital data converted by the analog-to-digital conversion module;
a random-access memory (RAM) (224-2);
a central processing unit (CPU) (224-3);
a graphics processing unit (GPU) (224-4); and
a peripheral interface module (224-5).

7. The computing-in-memory chip architecture according to any of claims 1 to 6, wherein the one or more arrays of computing-in-memory cells are integrated, through a first process node, on the first sub-chip, and the peripheral analog circuit IP core and the digital circuit IP core are integrated, through a second process node different from the first process node, on the second sub-chip.

8. The computing-in-memory chip architecture according to claim 7, wherein a line width of the second process node is less than that of the first process node.

9. The computing-in-memory chip architecture according to any of claims 1 to 6, wherein the one or more arrays of computing-in-memory cells, and the peripheral analog circuit IP core and the digital circuit IP core are respectively integrated, through a same process node, on the one or more first sub-chips and the second sub-chip.

10. A packaging method (400) for a computing-in-memory chip, wherein the computing-in-memory chip comprises one or more first sub-chips integrated on a first side and a second sub-chip integrated on a second side opposite to the first side, the method comprising:
integrating (S410) one or more arrays of computing-in-memory cells on the one or more first sub-chips, wherein the one or more arrays of computing-in-memory cells are used to compute the received data;
integrating (S420) a peripheral analog circuit IP core and a digital circuit IP core on the second sub-chip; and
communicatively coupling (S430), through an interface module, the second sub-chip to each of the one or more first sub-chips.

11. The packaging method according to claim 10, wherein the computing-in-memory chip further comprises an interposer between the one or more first sub-chips and the second sub-chip and integrated on the second side of the computing-in-memory chip; or
wherein the interface module comprises a through-silicon via (TSV) structure; or
wherein the one or more arrays of computing-in-memory cells, and the peripheral analog circuit IP core and the digital circuit IP core are integrated, through a same process node, on the one or more first sub-chips and the second sub-chip, respectively.

12. The packaging method according to claim 11, wherein the interface module comprises one or more sub-interface modules on each first sub-chip and aligned with each other, and
wherein the interposer comprises a first portion aligned with the one or more sub-interface modules on each first sub-chip, and a second portion configured to arrange a communication path between the second sub-chip and each first sub-chip.

13. The packaging method according to any of claims 10 to 12, wherein integrating the one or more arrays of computing-in-memory cells on the one or more first sub-chips comprises integrating, through a first process node, the one or more arrays of computing-in-memory cells on the one or more first sub-chips, and wherein integrating the peripheral analog circuit IP core and the digital circuit IP core on the second sub-chip comprises integrating, through a second process node different from the first process node, the peripheral analog circuit IP core and the digital circuit IP core on the second sub-chip; and optionally
wherein a line width of the second process node is less than that of the first process node.

14. The packaging method according to any of the claims 10 to 13, wherein the peripheral analog circuit IP core comprises one or more of:
a programming circuit module coupled to the one or more arrays of computing-in-memory cells and configured to perform data programming on the one or more arrays of computing-in-memory cells;
a digital-to-analog conversion module coupled to the one or more arrays of computing-in-memory cells and configured to convert digital data to be input to the one or more arrays of computing-in-memory cells into analog data;
an analog-to-digital conversion module coupled to the one or more arrays of computing-in-memory cells and configured to convert analog data computed by the one or more arrays of computing-in-memory cells into digital data;
a phase-locked loop; and
an oscillator; and optionally
wherein the digital circuit IP core comprises one or more of:
a post-processing operation circuit configured to perform a post-processing operation on the digital data converted by the analog-to-digital conversion module;
a random-access memory (RAM);
a central processing unit (CPU);
a graphics processing unit (GPU); and
a peripheral interface module.

15. An apparatus comprising the computing-in-memory chip architecture according to any of claims 1 to 9.
